(19) Europäisches Patentamt
European Patent Office
Office européen des brevets

(11) EP 3 348 518 A1

(12) DEMANDE DE BREVET EUROPEEN

(43) Date de publication:
18.07.2018 Bulletin 2018/29

(51) Int Cl.:
B82Y 10/00 (2011.01)   H01L 33/44 (2010.01)
H01L 33/06 (2010.01)   H01L 33/20 (2010.01)
H01S 5/34 (2006.01)

(21) Numéro de dépôt: 18151129.6

(22) Date de dépôt: 11.01.2018

(84) Etats contractants désignés:
AL AT BE BG CH CY CZ DE DK EE ES FI FR GB
GR HR HU IE IS IT LI LT LU LV MC MK MT NL NO
PL PT RO RS SE SI SK SM TR
Etats d'extension désignés:
BA ME
Etats de validation désignés:
MA MD TN

(30) Priorité: 13.01.2017 FR 1750299

(71) Demandeur: Commissariat à l'énergie atomique
et aux énergies alternatives
75015 Paris (FR)

(72) Inventeurs:
• BOUTAMI, Salim
  38100 GRENOBLE (FR)
• PAUC, Nicolas
  38100 GRENOBLE (FR)

(74) Mandataire: Brevalex
95, rue d'Amsterdam
75378 Paris Cedex 8 (FR)

(54) SOURCE DE LUMIÈRE COLLIMATÉE, SON PROCÉDÉ DE FABRICATION ET SON UTILISATION POUR L'ÉMISSION DE PHOTONS UNIQUES

(57) L'invention porte sur une source de lumière collimatée, notamment une source de photons uniques. La source comprend une cavité en forme de pyramide inversée formée dans un substrat. Au moins une boîte quantique (Bq) apte à émettre de la lumière selon un front d'onde est agencée au niveau du sommet de la pyramide inversée et une structure à gradient d'indice (4) remplit la cavité. Cette structure présente un indice effectif qui décroit du centre de la base vers les flancs. De telle manière, le front d'onde de la lumière émise par l'au moins une boîte quantique est aplani.

L'invention s'étend au procédé de fabrication d'une telle source, et à son utilisation pour l'émission d'une séquence de photons uniques.

FIG. 5

**Description**

**DOMAINE TECHNIQUE**

Le domaine de l'invention est celui des sources de lumière, et plus particulièrement celui des sources de photons uniques.

**ÉTAT DE LA TECHNIQUE ANTÉRIEURE**

Les sources de photons uniques sont capables d'émettre un seul photon à la fois. Elles sont généralement constituées d'un émetteur de type boîte quantique, et l'émission d'un photon y est réalisée à partir d'une paire électron-trou injectée.

Ces sources ont pour intérêt l'étude fondamentale de processus optiques et quantiques, mais également la cryptographie quantique. En effet, si l'on est capable de transmettre de l'information en bits constitués chacun d'un photon unique, on peut se prémunir, ou du moins détecter, l'interception de messages.

Pour qu'une source de photons uniques soit utilisable, il faut être capable de collecter efficacement le photon émis. Pour cela, la source doit pouvoir émettre le photon de manière directive.

Une source de photons uniques bien connue est décrite dans l'article « Quantum dots as single-photon sources for quantum information processing » (D C Unitt et al 2005 J. Opt. B: Quantum Semiclass. Opt. 7 S129). Elle est constituée d'un pilier gravé par gravure ionique réactive, avec une boîte quantique en son sein entouré de miroirs de Braggs. Les miroirs de Bragg permettent de constituer une cavité Fabry-Pérot qui exacerbe la probabilité d'émission de la boîte quantique dans ce mode de résonance. Cependant, on s'aperçoit que ce type de source diverge. De plus, de par la forte résonance de cette source (fort temps de vie du photon émis dans la cavité), il existe un risque que le photon soit diffracté par la rugosité de bord de gravure du pilier.

Un autre type de source de photons uniques est présenté dans l'article « A highly efficient single-photon source based on a quantum dot in a photonic nanowire » (J Claudon et al., Nature Photonics 4, 174 - 177 (2010)). Cette source prend la forme d'un pilier dont la pointe supérieure est affinée par des conditions adéquates de gravure. Un miroir est disposé sous le pilier pour réfléchir la lumière vers le haut. Cette source est peu résonnante, ce qui évite de diffracter la lumière par rugosité. Par ailleurs, l'affinement en pointe du sommet du pilier permet d'élargir spatialement le mode du pilier, et donc de le rendre moins divergent angulairement. Cette source présente donc une bonne directivité d'émission.

Cependant le positionnement de la boîte quantique au sein d'un pilier nécessite un alignement précis, ce qui n'est pas chose aisée. Il est par ailleurs difficile de contrôler avec précision la forme donnée à la pointe du pilier, de sorte que la collimation de la source ne peut être bien contrôlée.

**EXPOSÉ DE L'INVENTION**

Un objectif de l'invention est de proposer une source de lumière collimatée qui ne présente pas ces inconvénients. A cet effet, l'invention propose une source de lumière collimatée comprenant une cavité pyramidale formée dans un substrat disposant d'une face avant. La cavité pyramidale présente un axe de symétrie, une base au niveau de la face avant du substrat, un centre de la base, des flancs et un sommet en-dessous du centre de la base le long de l'axe de symétrie. Au moins une boîte quantique apte à émettre de la lumière selon un front d'onde est agencée au niveau du sommet de la cavité pyramidale. Une structure à gradient d'indice remplit la cavité pyramidale. Son indice effectif décroît du centre de la base vers les flancs de telle manière à aplanir le front d'onde de la lumière émise par l'au moins une boîte quantique.

Certains aspects préférés mais non limitatifs de cette source sont les suivants :

- la structure à gradient d'indice présente une variation continue d'indice de réfraction du centre de la base vers les flancs ;
- la structure à gradient d'indice est un empilement de strates successivement déposées dans la cavité pyramidale conformément aux flancs, l'indice effectif de chaque strate augmentant graduellement d'une strate à l'autre dans la succession des strates déposées ;
- les strates présentent la même épaisseur;
- chaque strate comporte une première couche et une deuxième couche réalisées en des matériaux différents, l'épaisseur relative des premières et deuxièmes couches d'une strate variant graduellement d'une strate à l'autre dans la succession des strates déposées ;
- dans chaque strate le matériau de la première couche présente un indice de réfraction inférieur à l'indice de réfraction du matériau de la seconde couche, et dans laquelle un facteur de remplissage d'une strate par la première couche diminue d'une strate à l'autre dans la succession des strates déposées ;
- le matériau de la première couche est de la silice et le matériau de la seconde couche est du silicium amorphe ;
- elle comporte une unique boîte quantique ;
- la boîte quantique est agencée dans une couche diélectrique prise en sandwich entre deux couches semi-conductrices dopées l'une de type n, l'autre de type p ;
- elle comprend en outre une structure réfléchissante sur les flancs de la cavité pyramidale, par exemple un miroir de Bragg ou une couche métallique.

L'invention s'étend à l'utilisation de cette source pour l'émission d'une séquence de photons uniques, par exemple dans un processus de cryptographie quantique. L'invention porte également sur un procédé de fabrication d'une telle source de lumière collimatée.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

- les figures 1a-1f, 2a-2h et 3a-3e illustrent trois modes de réalisation possible d'un procédé de fabrication d'une source selon l'invention ;
- les figures 4a, 4b et 4c sont des schémas représentant les fronts d'onde émis respectivement par une source ne présentant pas de structure à gradient d'indice, une source présentant une structure à gradient d'indice mais non dotée d'un miroir, et une source présentant une structure à gradient d'indice et d'un miroir ;
- la figure 5 est un schéma d'une source conforme à l'invention ;
- les figures 6a, 6b et 6c représentent respectivement l'émission d'une source présentant seulement un miroir de Bragg, d'une source présentant un structure à gradient d'indice mais non dotée d'un miroir, et d'une source présentant une structure à gradient d'indice et dotée d'un miroir de Bragg.

## EXPOSÉ DÉTAILLÉ DE MODES DE RÉALISATION PARTICULIERS

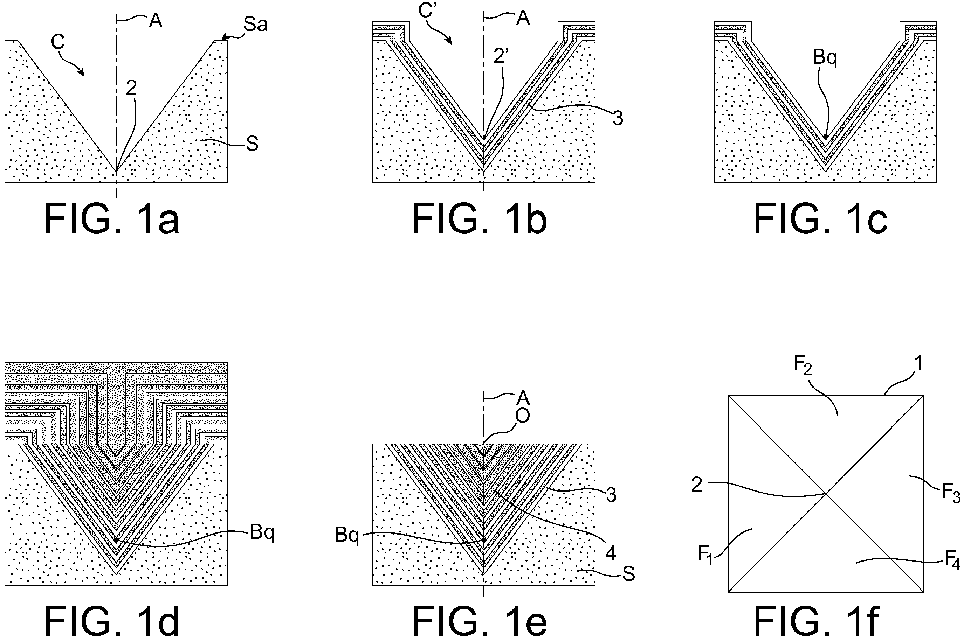

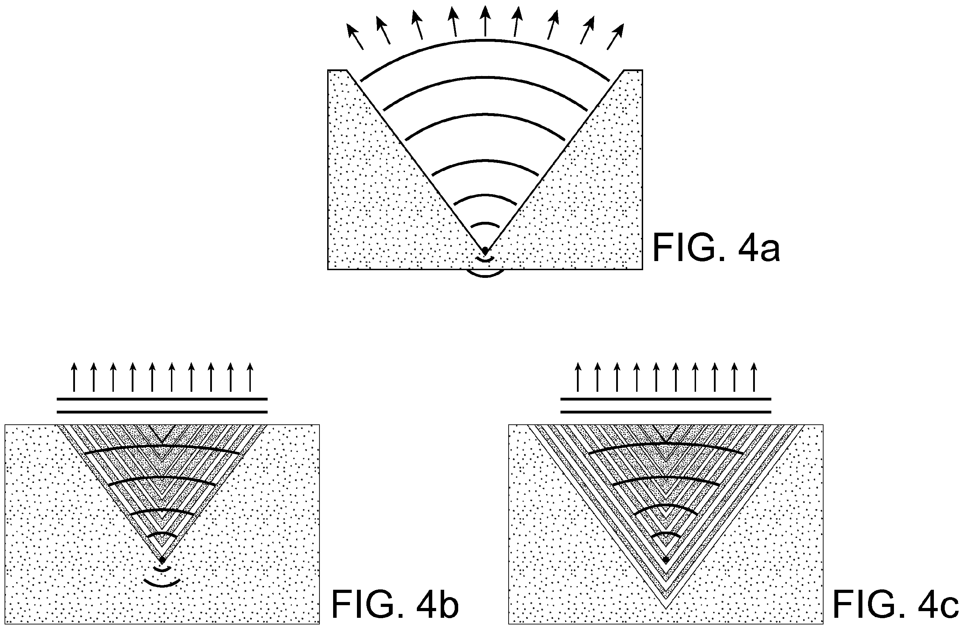

L'invention concerne une source de lumière collimatée, par exemple une source destinée à émettre une séquence de photons uniques.
En référence aux figures 1a-1f, la source comprend une cavité pyramidale C, C' formée dans un substrat S présentant une face avant Sa. La cavité pyramidale C, C' présente une base au niveau de la face avant Sa du substrat, la base comportant un centre O et un pourtour 1. La cavité pyramidale C, C' présente par ailleurs un axe de symétrie A passant par le centre C de la base, des flancs F1-F4 partant du pourtour de la base et se rejoignant en un sommet 2, 2' de la cavité situé en-dessous du centre O de la base le long de l'axe de symétrie A.
Les figures 1a-1e proposent des vues en coupe dans un plan perpendiculaire à la face avant du substrat passant par une diagonale de la base de la cavité pyramidale. La figure 1f est quant à elle une vue de dessus de la cavité sur laquelle on visualise les flancs F1-F4 (face de la pyramide).
Dans un mode de réalisation représenté sur la figure 1a, la cavité C est directement issue de gravure du substrat. Dans un mode de réalisation alternatif représenté sur la figure 1b, les flancs de la cavité C directement issue de gravure du substrat sont recouverts d'une structure réfléchissante 3, formant ainsi une cavité C' présentant un sommet 2' et dont les flancs sont formés par la structure réfléchissante.
La source comprend également au moins une boîte quantique Bq apte à émettre de la lumière selon un front d'onde. L'au moins une boîte quantique est agencée au niveau du sommet 2, 2' de la cavité pyramidale C, C'. Pour assurer l'émission de photons uniques, on prévoit une unique boîte quantique.
Une structure à gradient d'indice 4 remplit la cavité pyramidale. L'indice effectif de cette structure décroit du centre C vers les flancs F1-F4. De telle manière, le front d'onde de la lumière émise par l'au moins une boîte quantique Bq est aplani, venant ainsi collimater la lumière émise par l'au moins une boîte quantique. Par indice effectif, on désigne l'indice moyen vu par la lumière. Cet indice effectif peut être différent de l'indice de réfraction local, cet indice local correspondant par exemple à l'indice du ou des matériaux composant des strates d'un empilement formé dans la cavité pyramidale comme décrit ci-après.
On a représenté sur la figure 4a le front d'onde émis par une boîte quantique agencée au sommet d'une cavité pyramidale dénuée de structure à gradient d'indice. Ce front d'onde est sphérique, divergent. Un photon ainsi émis peut donc aller dans n'importe quelle direction, et il peut donc être difficile de le collecter.
On a représenté sur la figure 4b le front d'onde émis par une boîte quantique agencée au sommet d'une cavité pyramidale remplie d'une structure à gradient d'indice conformément à l'invention. La structure à gradient d'indice vient

3

aplanir le front d'onde, ce qui permet de collimater la lumière émise. Il en découle une collecte plus aisée du photon ainsi émis.

Sur la figure 4b, de la lumière part du sommet de la pyramide en direction du substrat. Pour éviter cela, on peut prévoir une structure réfléchissante sur les flancs de la cavité pyramidale. De ce fait, comme représenté sur la figure 4c, toute la lumière est émise vers le haut en étant collimatée.

On note ici qu'un photon unique ne peut pas à la fois aller en haut et en bas. Ainsi quand une simulation montre une partie de la lumière allant en haut, et une partie en bas, cela signifie qu'un photon unique a une certaine probabilité d'aller en haut, et une probabilité complémentaire d'aller en bas, ces probabilités étant au prorata des quantités de lumière données par simulation. Avec la structure réfléchissante, on impose que tous les photons vont en haut avec une probabilité de 1.

La formation de la cavité pyramidale comprend typiquement une gravure du substrat, par exemple une gravure humide anisotrope. La solution de gravure humide anisotrope est généralement du KOH (hydroxyde de potassium) ou du TMAH (hydroxyde de tétraméthylammonium). La cinétique de gravure est dépendante des plans cristallins, ce qui aboutit à la forme de pyramide inversée. On réalise au préalable un masque de résine sur la face avant du substrat, le masque présentant de petites ouvertures réalisées par lithogravures qui permettent de localiser et d'initier la gravure. Plus particulièrement, on peut utiliser un substrat de Si doté d'une couche superficielle de type $SiO_2$ ou $Si_3N_4$. On recouvre la couche superficielle d'un masque de résine défini par lithographie et on vient définir un masque dur par gravure humide ou sèche de la couche superficielle à travers le masque de résine. On enlève ensuite la résine et on procède alors à la gravure de la pyramide. A la fin de cette gravure, on peut enlever le masque dur par gravure sèche ou humide.

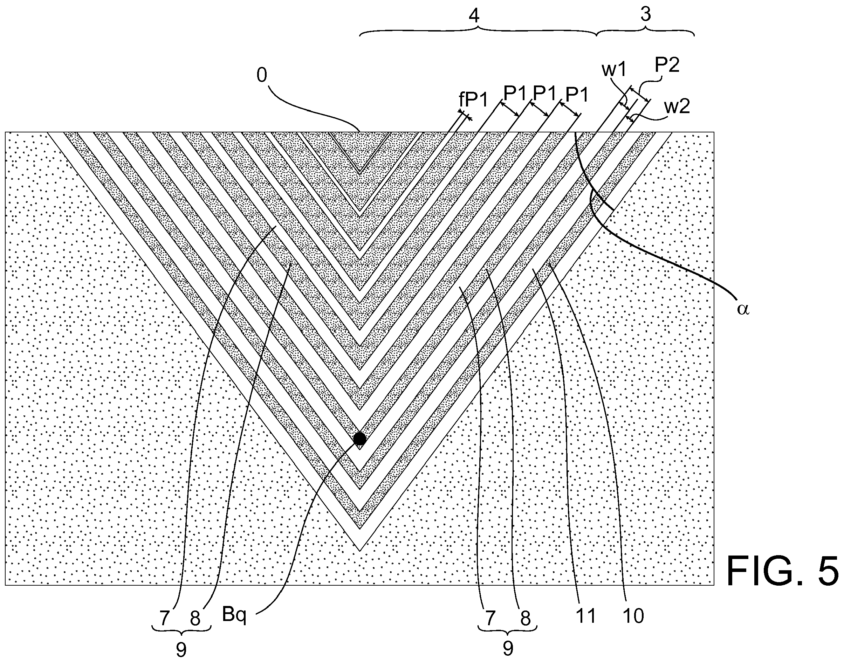

Le substrat est par exemple un substrat de silicium. Sa gravure chimique anisotrope donne lieu à la formation d'une pyramide inversée, avec un angle caractéristique de 54.7° entre un flanc de la cavité et le plan horizontal correspondant à la face avant du substrat. Cet angle est désigné par $\alpha$ sur la figure 5.

Le substrat peut également être réalisé en un matériau III-V, par exemple en InP ou en InGaAs qui peuvent également être gravés de manière humide anisotrope.

La base de la cavité pyramidale peut prendre des formes diverses, notamment en fonction de la nature du cristal. Elle peut notamment être carrée ou hexagonale. Elle doit présenter une dimension supérieure à la longueur d'onde émise pour éviter les phénomènes de diffraction.

L'agencement au niveau du sommet de la cavité pyramidale de l'au moins une boîte quantique peut comprendre le dépôt d'une solution colloïdale de boîtes quantiques sur le substrat. Par capillarité, ces boîtes quantiques viennent se déposer au fond des cavités pyramidales. Un auto-alignement est ainsi réalisé.

Le contrôle de la concentration en boîtes quantiques dans la solution colloïdale permet de contrôler le nombre de cavités équipées d'une seule boîte quantique. On choisit ainsi de préférence une concentration d'une boîte quantique par volume d'une cavité pyramidale. On peut venir vérifier qu'il n'y a qu'une boîte quantique dans une cavité en réalisant la photoluminescence du fond de la pyramide et en venant vérifier que le signal optique émis correspond à la signature spectrale d'un émetteur unique (observation de raies d'origine excitonique voire multiexcitonique, ainsi que l'observation du dégroupement de photons, *antibunching,* sur la raie d'émission impliquant l'émission d'un seul photon à un temps donné).

Dans une variante de réalisation, on vient fabriquer une résine pour lithographie à faisceau d'électrons, ladite résine étant enrichie en boîtes quantiques colloïdales. L'échantillon est enduit par cette résine, y compris aussi au fond des pyramides. Une lithographie à faisceau d'électrons permet de laisser un plot de résine au fond de la pyramide contenant une boîte quantique colloïdale. Un plasma oxygène permet d'enlever la résine pour ne conserver que la boîte quantique.

Lorsque le substrat est en matériau III-V, en raison de la compatibilité des matériaux, on peut réaliser la croissance de boîtes quantiques directement depuis le sommet des cavités.

La structure à gradient d'indice qui remplit la cavité peut présenter une variation continue d'indice de réfraction. On peut pour cela continûment modifier la composition d'un alliage (par exemple SiGe déposé par épitaxie) ou la composition d'un mélange de matériaux (par exemple $Nb_2O_5/SiO_2$, $SiN/SiO_2$ ou $TiO_2/SiO_2$) lors de la formation de la structure à gradient d'indice dans la cavité par dépôt d'un tel alliage ou d'un tel mélange dans la cavité conformément aux flancs.

Dans un mode de réalisation alternatif, le remplissage d'une cavité pyramidale par une structure à gradient d'indice dont l'indice effectif décroît du centre de la base vers les flancs de la cavité peut comprendre la formation d'un empilement de strates dans la cavité, les strates étant successivement déposées dans la cavité pyramidale conformément aux flancs.

L'indice effectif de chaque strate augmente graduellement d'une strate à l'autre dans la succession des strates déposées. Ainsi, au niveau de la base, l'indice effectif est plus faible au niveau du pourtour (1ère strate déposée) qu'au centre (dernière strate déposée). On réalise de telle manière un pseudo-gradient d'indice (la variation d'indice présente un caractère discret approximant une variation continue).

Les strates présentent de préférence la même épaisseur, notée P1 sur la figure 5. Cette épaisseur est avantageusement suffisamment faible pour que le pseudo-gradient d'indice permette d'approximer un véritable gradient d'indice, soit inférieure à $\lambda/2$ (avec $\lambda$ la longueur d'onde d'émission).

Dans un mode de réalisation, les strates sont des dépôts d'un alliage ou d'un mélange de matériaux dont la composition diffère d'une state à l'autre.

Dans un autre mode de réalisation représenté notamment sur la figure 5, les strates 9 sont des bicouches. Chaque bicouche présente une première couche 7 et une deuxième couche 8 réalisées en des matériaux différents. L'épaisseur relative des premières et deuxièmes couches d'une strate varie graduellement d'une strate à l'autre dans la succession des strates déposées.

Dans chaque bicouche, le matériau de la première couche présente un indice de réfraction inférieur à l'indice de réfraction du matériau de la seconde couche. Un facteur de remplissage d'une strate par la première couche diminue d'une strate à l'autre dans la succession des strates déposées.

Le matériau de la première couche 7 peut être de la silice (indice $n_{SiO2}=1,5$), le matériau de la seconde couche 8 étant du silicium amorphe (indice $n_{Si}=3,5$). Prenant cet exemple de réalisation, on note f le taux de silice local qui est fonction de la distance x depuis le centre de la base de la cavité pyramidale le long d'une diagonale de la base de la cavité pyramidale. L'indice effectif s'exprime selon :

$$\hat{n}(x) = \sqrt{f(x).n_{SiO2}^2 + (1-f(x)).n_{Si}^2} \qquad (1)$$

Pour assurer la collimation, la variation d'indice local doit vérifier approximativement la relation suivante pour compenser la différence de distance parcourue par la lumière depuis le sommet de la pyramide entre le centre de la base et un point de la base situé à une distance x du centre :

$$\hat{n}(x) = \hat{n}(0).\frac{\tan \alpha.X}{\sqrt{x^2+\tan^2 \alpha.X^2}} \qquad (2)$$

où X désigne la longueur d'une demi-diagonale de la base de la pyramide (x=X désignant l'intersection de la diagonale et du pourtour de la base), et où $\alpha$ correspond à l'angle de gravure.

On a en particulier

$$\hat{n}(X) = \hat{n}(0).\sin \alpha \qquad (3)$$

$\hat{n}(X) = \hat{n}(0). \sin \alpha$ (3)

Avec un angle de gravure $\alpha=54,7°$ pour le silicium, on peut par exemple adopter les indices suivants : $\hat{n}(0) = 3$ et $\hat{n}(X) = 2,5$.

Le facteur de remplissage de la silice évolue d'après les équations précédentes selon

$$f(x) = \frac{n_{Si}^2-(\hat{n}(0)^2*\frac{\tan^2 \alpha.X^2}{x^2+\tan^2 \alpha.X^2})}{n_{Si}^2-n_{SiO2}^2}.$$

Sur la figure 5, l'épaisseur de la couche de silice d'un bicouche est notée f.P1, l'épaisseur de la couche de silicium étant (1-f).P1 de sorte que le bicouche présente l'épaisseur P1.

On a vu précédemment que les flancs de la cavité peuvent être recouverts d'une structure réfléchissante 3. Une telle structure est formée après la gravure de la cavité pyramidale et avant l'agencement de l'au moins une boîte quantique dans celle-ci. Dans les formules précédentes, en cas de présence d'une telle structure réfléchissante, X correspond à la frontière entre la structure de gradient d'indice 4 et la structure réfléchissante 3.

En référence par exemple à la figure 5, la structure réfléchissante 3 est par exemple un miroir de Bragg déposé sur les flancs de la cavité à l'issue de la gravure du substrat. Un tel miroir de Bragg est une alternance de couches d'indices optiques différents, par exemple des couches de silice et de silicium. Il s'agit de couches quart d'ondes, ou multiples impaires de quart d'ondes. On choisit de préférence des couches quart d'ondes qui présentent l'intérêt d'être réfléchissantes sur une grande gamme d'angles d'incidence. Le miroir de Bragg est par exemple constitué d'un empilement de bicouches Si/SiO2, chaque bicouche présentant une épaisseur $P2= \lambda/4$-$n_{Si} + \lambda/4n_{SiO2}$. Dans l'exemple de la figure 5, le miroir de Bragg 3 comprend trois bicouches Si/SiO2 d'épaisseur P2, chaque bicouche comprenant une couche de silice 10 d'épaisseur $w1= \lambda/4n_{SiO2}$ et une couche de silicium 11 d'épaisseur $w2= \lambda/4n_{Si}$.

Un avantage de la configuration en pyramide est que le miroir de Bragg n'est pas planaire, mais entoure la boîte quantique. Il voit donc toujours un front d'onde à peu près en incidence normale, ce qui lui permet d'être efficace (un miroir de Bragg fonctionne moins efficacement à fort angle d'incidence).

Dans une variante de réalisation, la structure réfléchissante comprend une couche métallique (par exemple en aluminium, cuivre ou or) déposée sur les flancs de la cavité issue de la gravure du substrat, et une couche d'espacement, par exemple un diélectrique tel que la silice, recouvrant la couche métallique et permettant d'éviter un contact entre la boîte quantique et la couche métallique. Cette couche d'espacement est par exemple une couche quart d'onde.

Des simulations par calcul de différences finies dans le domaine temporel ont été réalisées à la longueur d'onde télécom de $\lambda=1,55$ $\mu$m. Elles portent sur une source (i) non conforme à l'invention en ce qu'elle est dénuée de structure à gradient d'indice (cf. figure 4a), une source (ii) conforme à l'invention ne présentant pas de structure réfléchissante (cf. figure 4b), et une autre source (iii) conforme à l'invention présentant une structure réfléchissante de type miroir de Bragg (cf. figure 4c).

Pour ces trois sources, la cavité issue de la gravure présente une profondeur maximale (hauteur de la pyramide) de 10 $\mu$m. Dans les sources (ii) et (iii), la structure à gradient d'indice présente une période P1=0,15 $\mu$m et le facteur de remplissage f de silice dans les bicouches silicium amorphe - silice varie de 20% à 80%. Dans la source (iii), le miroir de Bragg comporte trois bicouches avec w1=0,26 $\mu$m et w2=0,11 $\mu$m.

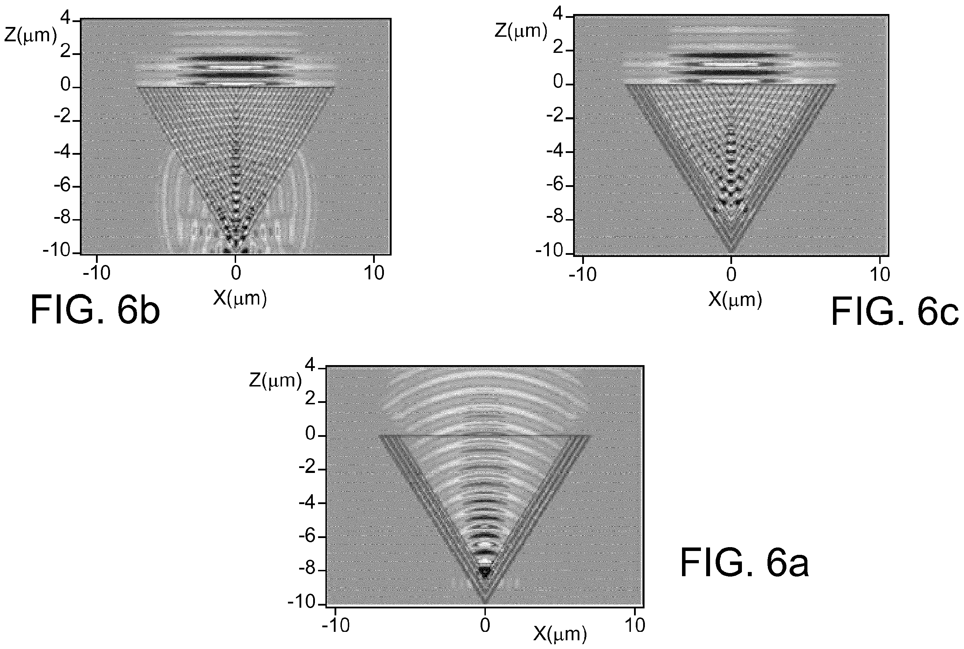

La simulation de la source (i) est représentée sur la figure 6a. On constate une émission isotrope, avec un front d'onde sphérique non collimaté. Les simulations des sources (ii) et (iii) sont respectivement représentées sur les figures 6b et 6c. On constate que la lumière est bien collimatée avec un front d'onde aplani par la structure à gradient d'indice. Une comparaison de ces figures montre par ailleurs que le miroir de Bragg permet d'obtenir une émission entièrement dirigée vers le haut.

Un autre intérêt de l'invention réside dans le fait que l'on peut appliquer un facteur d'échelle à la pyramide, la lumière restant toujours collimatée. En effet, même si l'on réduit la taille de la pyramide, c'est-à-dire X, tant que la relation d'indice (2) indiquée précédemment est vérifiée, l'invention fonctionne de manière homothétique, la relation (3) ne dépendant pas de X. L'invention peut ainsi être appliquée à n'importe quelle taille de pyramide, et donc fournir n'importe quelle directivité souhaitée, car plus le faisceau d'émission est large, meilleure est la directivité angulaire.

On a représenté sur les figures 1a-1e, 2a-2h et 3a-3e trois modes de réalisation possible d'un procédé de fabrication d'une source selon l'invention.

Le premier mode de réalisation comprend la gravure du substrat S pour y former une cavité issue de la gravure C (figure 1a). On procède ensuite au dépôt éventuel du miroir de Bragg 3 sur les flancs de la cavité C issue de gravure, formant ainsi une cavité pyramidale C' aux flancs réfléchissants (figure 1b). On positionne ensuite une boîte quantique Bq au sommet 2' de la cavité pyramidale (figure 1c). On vient ensuite déposer les différentes strates de la structure à gradient d'indice 4 (figure 1d). Enfin, on procède à une planarisation mécano-chimique CMP (« Chemical Mechanical Polishing ») ou bien à une gravure pour planariser jusqu'à affleurement de la face avant Sa du substrat (figure 1e).

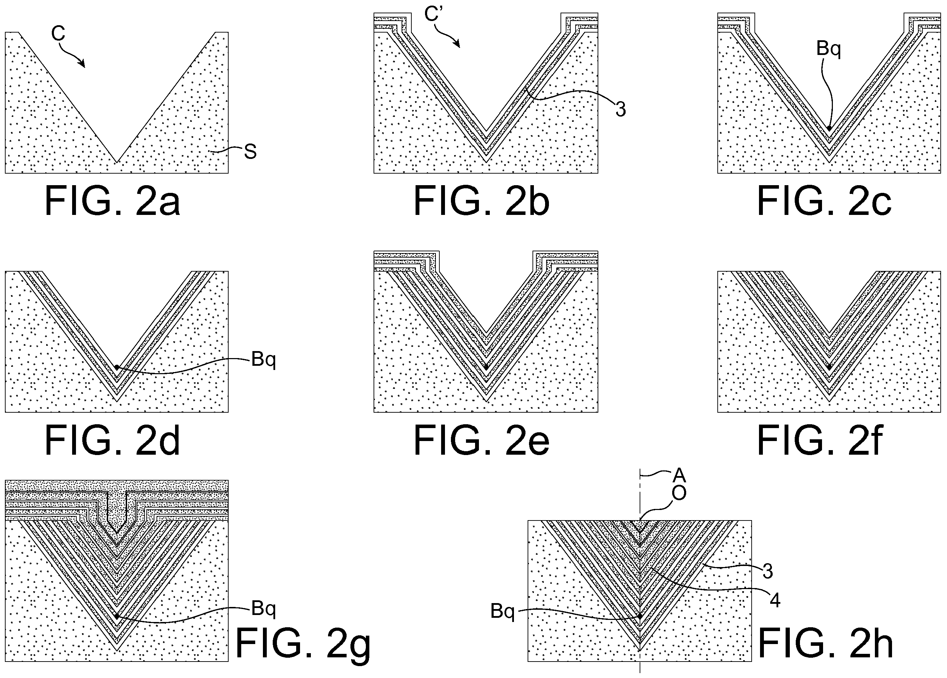

Les trois premières étapes du deuxième mode de réalisation (figures 2a-2c) sont identiques à celles du premier mode de réalisation. Ce deuxième mode se distingue du premier en ce que plusieurs gravures ou CMP intermédiaires sont réalisées. Ainsi, en référence à la figure 2d, une gravure ou CMP est réalisée jusqu'à affleurer la face avant du substrat. Puis une partie de la structure à gradient d'indice 4 est déposée (figure 2e). Une nouvelle gravure ou CMP est réalisée (figure 2f), avant que la fin de la structure à gradient d'indice 4 ne soit déposée (figure 2g) et qu'une gravure ou planarisation finale ne soit réalisée (figure 2h).

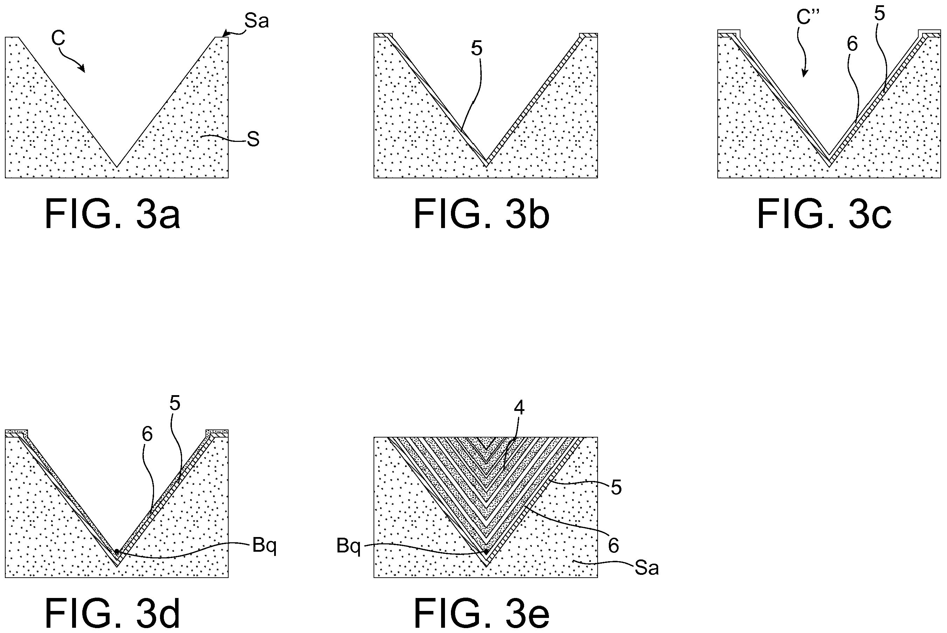

Le troisième mode de réalisation comprend la gravure du substrat S pour y former une cavité issue de gravure C (figure 3a). On procède ensuite au dépôt d'un miroir métallique 5 (figure 3b) que l'on vient recouvrir d'une couche d'espacement (figure 3c) pour former une cavité pyramidale C" aux flancs réfléchissants. On procède ensuite au placement de la boîte quantique Bq (figure 3d) et à la formation de la structure à gradient d'indice 4 (figure 3e).

L'invention porte également sur l'utilisation de la source telle que décrite précédemment pour l'émission d'une séquence de photons uniques.

Le dispositif peut alors être constitué d'un laser de pompe impulsionnel et d'un couple de deux détecteurs rapides de type APD (photodiode à avalanche) couplées à un compteur d'impulsions assurant la mesure de la fonction de corrélation. Les deux détecteurs sont chacun situés de part et d'autre d'une lame semi-réfléchissante recevant le flux de photons en provenance de l'échantillon excité par le laser.

Dans une réalisation alternative au pompage optique, on peut réaliser une injection électrique par effet tunnel dans la boite quantique. A cet effet, la boîte quantique est agencée dans une couche diélectrique prise en sandwich entre deux couches semi-conductrices dopées l'une de type n, l'autre de type p. La couche diélectrique est par exemple un oxyde tel que la silice, et les couches dopées sont par exemple des couches de silicium. L'épaisseur de la couche diélectrique est de quelques nanomètres, adaptée à la taille de la boîte quantique.

Les couches dopées étant déposées pleine plaque, on les retrouve non seulement au fond de la cavité pyramidale mais également en surface du substrat où l'on peut aisément prendre des contacts métalliques avec ces couches à l'aide de pistes ou des pointes métalliques. Ces contacts électriques permettent de réaliser une injection électrique, le courant ne pouvant passer d'une couche dopée à l'autre en raison de la couche diélectrique, sauf par la boîte quantique par effet tunnel. En forçant ainsi le courant à passer par la boîte, une bonne efficacité d'injection est assurée, l'injection d'une paire électron-trou permettant l'émission d'un photon.

Cette injection électrique est compatible avec la présence d'une structure réfléchissante sur les flancs de la cavité. Lorsque cette structure prend la forme d'une couche métallique, la couche dopée au contact de la couche métallique sert de couche d'espacement. Il s'agit de préférence d'une couche quart d'onde. La couche métallique peut être utilisée en surface du substrat pour la prise de contact électrique, alternativement à la couche dopée en contact de la couche métallique.

Lorsque la structure réfléchissante prend la forme d'un miroir de Bragg, la dernière couche du miroir (i.e. la couche supérieure) peut être une couche semiconductrice dopée de manière à former l'une des couches dopées de l'injection électrique. Cette couche est une couche quart d'onde.

## Revendications

1. Source de lumière collimatée, comprenant :

   - une cavité pyramidale (C, C', C") formée dans un substrat (S) disposant d'une face avant (Sa), la cavité pyramidale présentant un axe de symétrie (A), une base au niveau de la face avant du substrat, un centre (0) de la base, des flancs (F1-F4) et un sommet (S) en-dessous du centre de la base le long de l'axe de symétrie,
   - au moins une boîte quantique (Bq) apte à émettre de la lumière selon un front d'onde, l'au moins une boîte quantique étant agencée au niveau du sommet de la cavité pyramidale, et
   - une structure à gradient d'indice (4) qui remplit la cavité pyramidale et dont l'indice effectif décroît du centre de la base vers les flancs de telle manière à aplanir le front d'onde de la lumière émise par l'au moins une boîte quantique.

2. Source selon la revendication 1, dans lequel la structure à gradient d'indice présente une variation continue d'indice de réfraction du centre de la base vers les flancs.

3. Source selon la revendication 1, dans laquelle la structure à gradient d'indice (4) est un empilement de strates (9) successivement déposées dans la cavité pyramidale conformément aux flancs.

4. Source selon la revendication 3, dans laquelle l'indice effectif de chaque strate (9) augmente graduellement d'une strate à l'autre dans la succession des strates déposées.

5. Source selon l'une des revendications 3 et 4, dans laquelle les strates (9) présentent la même épaisseur.

6. Source selon la revendication 5, dans laquelle chaque strate comporte (9) une première couche (8) et une deuxième couche (7) réalisées en des matériaux différents, l'épaisseur relative des premières et deuxièmes couches d'une strate variant graduellement d'une strate à l'autre dans la succession des strates déposées.

7. Source selon la revendication 6, dans laquelle dans chaque strate le matériau de la première couche (8) présente un indice de réfraction inférieur à l'indice de réfraction du matériau de la seconde couche (7), et dans laquelle un facteur de remplissage d'une strate par la première couche diminue d'une strate à l'autre dans la succession des strates déposées.

8. Source selon la revendication 7, dans laquelle le matériau de la première couche (8) est de la silice et le matériau de la seconde couche (7) est du silicium amorphe.

9. Source selon l'une des revendications 1 à 8, comprenant une unique boîte quantique.

10. Source selon l'une des revendications 1 à 9, dans laquelle la boîte quantique est agencée dans une couche diélectrique prise en sandwich entre deux couches semi-conductrices dopées l'une de type n, l'autre de type p.

11. Source selon l'une des revendications 1 à 10, comprenant en outre une structure réfléchissante (3) sur les flancs de la cavité pyramidale, par exemple un miroir de Bragg ou une couche métallique.

12. Utilisation de la source selon la revendication 9, pour l'émission d'une séquence de photons uniques.

13. Procédé de fabrication d'une source de lumière collimatée, comprenant :

- la formation d'une cavité pyramidale (C, C', C") dans un substrat présentant une face avant, la cavité pyramidale présentant un axe de symétrie (A), une base au niveau de la face avant du substrat, un centre (0) de la base, des flancs (F1-F4) et un sommet (S) en-dessous du centre le long de l'axe de symétrie,
- l'agencement au niveau du sommet de la cavité pyramidale d'au moins une boîte quantique (Bq) apte à émettre de la lumière selon un front d'onde, et
- le remplissage de la cavité pyramidale par une structure à gradient d'indice (4) dont l'indice effectif décroit du centre de la base vers les flancs.

14. Procédé selon la revendication 13, dans lequel l'agencement au niveau du sommet de la cavité pyramidale de l'au moins une boîte quantique comprend un dépôt d'une solution colloïdale de boîtes quantique sur le substrat.

15. Procédé selon l'une des revendications 13 et 14, dans lequel l'agencement de l'au moins une boîte quantique au niveau du sommet de la cavité pyramidale est précédé d'une étape de formation d'une structure réfléchissante (3) sur les flancs de la cavité pyramidale, par exemple un miroir de Bragg ou une couche métallique.

EP 3 348 518 A1

FIG. 1a

FIG. 1b

FIG. 1c

FIG. 1d

FIG. 1e

FIG. 1f

EP 3 348 518 A1

FIG. 2a

FIG. 2b

FIG. 2c

FIG. 2d

FIG. 2e

FIG. 2f

FIG. 2g

FIG. 2h

FIG. 3a

FIG. 3b

FIG. 3c

FIG. 3d

FIG. 3e

EP 3 348 518 A1

FIG. 4a

FIG. 4b

FIG. 4c

FIG. 5

EP 3 348 518 A1

FIG. 6b

FIG. 6c

FIG. 6a

EP 3 348 518 A1

Europäisches
Patentamt

European
Patent Office

Office européen
des brevets

# RAPPORT DE RECHERCHE EUROPEENNE

Numéro de la demande

EP 18 15 1129

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | A Hartmann ET AL: "Structure and optical properties of semiconductor quantum nanostructures self-formed in inverted tetrahedral pyramids", J. Phys.: Condens. Matter, 9 août 1999 (1999-08-09), pages 5901-5915, XP055398978, Extrait de l'Internet: URL:http://iopscience.iop.org/article/10.1088/0953-8984/11/31/302/pdf [extrait le 2017-08-16] | 1,3-5,9, 11-13,15 | INV. B82Y10/00 H01L33/44 ADD. H01L33/06 H01L33/20 H01S5/34 |
| A | * abrégé * * 2.Structural Characterization; page 5902 - page 5904; figures 2, 4, 8 * ----- | 2,6-8, 10,14 | |
| Y | JP H06 45648 A (OMRON TATEISI ELECTRONICS CO) 18 février 1994 (1994-02-18) * abrégé * * alinéa [0017] - alinéa [0022]; figure 1 * * alinéa [0025] - alinéa [0028]; figure 3 * ----- | 1,3-5,9, 11-13,15 | |
| A | BAIER M H ET AL: "Electroluminescence from a single pyramidal quantum dot in a light-emitting diode", APPLIED PHYSICS LETTERS, A I P PUBLISHING LLC, US, vol. 84, no. 11, 15 mars 2004 (2004-03-15) , pages 1967-1969, XP012060804, ISSN: 0003-6951, DOI: 10.1063/1.1687453 * abrégé * * page 1967, ligne 1 - ligne 4 * ----- -/-- | 1,12 | DOMAINES TECHNIQUES RECHERCHES (IPC) B82Y H01L H01S |

Le présent rapport a été établi pour toutes les revendications

| Lieu de la recherche | Date d'achèvement de la recherche | Examinateur |
|---|---|---|
| La Haye | 14 mai 2018 | Dehestru, Bastien |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons

& : membre de la même famille, document correspondant

EPO FORM 1503 03.82 (P04C02)

page 1 de 2

Europäisches
Patentamt

European
Patent Office

Office européen
des brevets

**RAPPORT DE RECHERCHE EUROPEENNE**

Numéro de la demande

EP 18 15 1129

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | ASPNES D E ET AL: "Optical properties of AlxGa1-xAs", JOURNAL OF APPLIED PHYSICS, AMERICAN INSTITUTE OF PHYSICS, US, vol. 60, no. 2, 15 juillet 1986 (1986-07-15), pages 754-767, XP002514590, ISSN: 0021-8979, DOI: 10.1063/1.337426 * abrégé; tableaux II-IX * | 1,13 | |
| A | SEJEONG KIM ET AL: "Unidirectional Emission of a Site-Controlled Single Quantum Dot from a Pyramidal Structure", NANO LETTERS, vol. 16, no. 10, 12 octobre 2016 (2016-10-12), pages 6117-6123, XP055398305, US ISSN: 1530-6984, DOI: 10.1021/acs.nanolett.6b02331 * le document en entier * | 1,2,6-8, 13 | |
| A | US 2012/112165 A1 (CHARLTON MARTIN DAVID BRIAN [GB] ET AL) 10 mai 2012 (2012-05-10) * abrégé * * alinéas [0179], [0182] - [0183]; figure 17D * * alinéa [0051] * * alinéas [0132] - [0133]; figure 2A * * alinéa [0123] - alinéa [0131]; figure 1 * | 1,10,12, 14 | DOMAINES TECHNIQUES RECHERCHES (IPC) |

Le présent rapport a été établi pour toutes les revendications

| Lieu de la recherche | Date d'achèvement de la recherche | Examinateur |
|---|---|---|
| La Haye | 14 mai 2018 | Dehestru, Bastien |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

page 2 de 2

EP 3 348 518 A1

## ANNEXE AU RAPPORT DE RECHERCHE EUROPEENNE
## RELATIF A LA DEMANDE DE BREVET EUROPEEN NO.

EP 18 15 1129

14-05-2018

| Document brevet cité au rapport de recherche | Date de publication | Membre(s) de la famille de brevet(s) | Date de publication |
|---|---|---|---|
| JP H0645648 A | 18-02-1994 | AUCUN | |
| US 2012112165 A1 | 10-05-2012 | CN 102396065 A | 28-03-2012 |
| | | EP 2396818 A2 | 21-12-2011 |
| | | KR 20110131212 A | 06-12-2011 |
| | | US 2012112165 A1 | 10-05-2012 |
| | | WO 2010092362 A2 | 19-08-2010 |

EPO FORM P0460

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **D C UNITT et al.** Quantum dots as single-photon sources for quantum information processing. *J. Opt. B: Quantum Semiclass. Opt.,* 2005, vol. 7, S129

- **J CLAUDON et al.** A highly efficient single-photon source based on a quantum dot in a photonic nanowire. *Nature Photonics,* 2010, vol. 4, 174-177